# EUROPEAN PATENT SPECIFICATION

(11) **EP 2 764 555 B1**
(45) Date of publication and mention of the grant of the patent: **17.01.2018**
(21) Application number: 12838998.8
(22) Date of filing: 04.10.2012
(51) Int. Cl.: H01L 35/00, H01L 35/30, H01L 35/32, F01N 5/02, H01L 35/34

(54) **INTEGRATED ASSEMBLY OF MICRO HEAT EXCHANGER AND THERMOELECTRIC MODULE**
INTEGRIERTE ANORDNUNG AUS EINEM MIKROTAUSCHER UND EINEM THERMOELEKTRISCHEN MODUL
ENSEMBLE INTÉGRÉ CONSTITUÉ D'UN MICRO-ÉCHANGEUR DE CHALEUR ET D'UN MODULE THERMOÉLECTRIQUE

(30) Priority: 04.10.2011 US 201161542835 P
(43) Date of publication of application: 13.08.2014
(73) Proprietor: BASF SE, 67056 Ludwigshafen am Rhein (DE)
(72) Inventor: MOORS, Jürgen, 67434 Neustadt (DE); RENZE, Peter, 68163 Mannheim (DE); MARUDHACHALAM, Panneerselvam, 67067 Ludwigshafen (DE); LEAVITT, Frederick, A., San Diego, CA 92129 (US); MCCOY, John, Washington, San Diego, CA 92103 (US)
(86) International application number: PCT/IB2012/055332
(87) International publication number: WO 2013/050961

(56) References cited:
- EP-A1- 2 180 534
- CN-A- 101 114 691
- DE-A1-102006 057 662
- JP-A- H04 273 484
- US-A- 5 875 098
- US-A1- 2005 217 714
- US-A1- 2010 212 712
- US-A1- 2011 016 888
- US-A1- 2012 125 015

## Description

The invention relates to thermoelectric modules which are suitable for fitting in the exhaust system of an internal combustion engine.

Thermoelectric generators and Peltier arrangements per se have been known for a long time. p- and n-doped semiconductors, which are heated on one side and cooled on the other side, transport electric charges through an external circuit, so that electrical work can be performed on a load in the circuit. The efficiency thereby achieved for the conversion of heat into electrical energy is thermodynamically limited by the Carnot efficiency. Thus, with a temperature of 1000 K on the hot side and 400 K on the "cold" side, an efficiency of (1000 - 400) ÷ 1000 = 60% would be possible. To date, however, only efficiencies up to 6% have been achieved.

If on the other hand a direct current is applied to such an arrangement, then heat is transported from one side to the other side. Such a Peltier arrangement works as a heat pump and is therefore suitable for cooling equipment parts, vehicles or buildings. Heating by means of the Peltier principal is also more favorable than conventional heating, because more heat is always transported than corresponds to the energy equivalent supplied.

At present, thermoelectric generators are used in space probes for the generation of direct currents, for the cathodic corrosion protection of pipelines, for the energy supply of light and radio buoys, and for the operation of radios and televisions. The advantages of thermoelectric generators reside in their extreme reliability. They operate irrespective of atmospheric conditions such as relative humidity; no material transport susceptible to interference takes place, rather only charge transport.

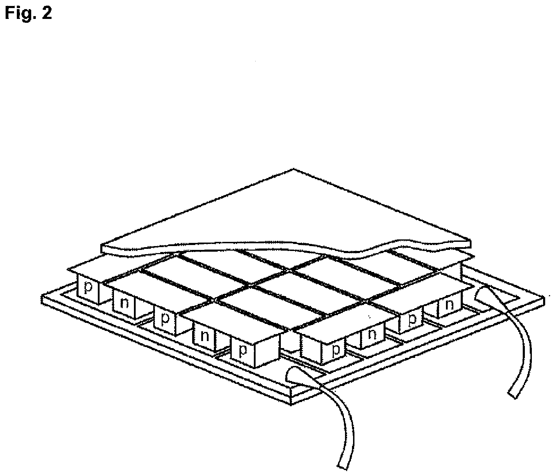

A thermoelectric module consists of p- and n-type pieces which are connected electrically in series and thermally in parallel. Figure 2 shows such a module.

The conventional structure consists of two ceramic plates, between which the individual pieces are fitted alternately. Two pieces are in each case contacted electrically conductively via the end faces.

Besides the electrically conductive contacting, various further layers are normally also provided on the actual material, which serve as protective layers or as solder layers. Lastly, however, the electrical contact between two pieces is established via a metal bridge.

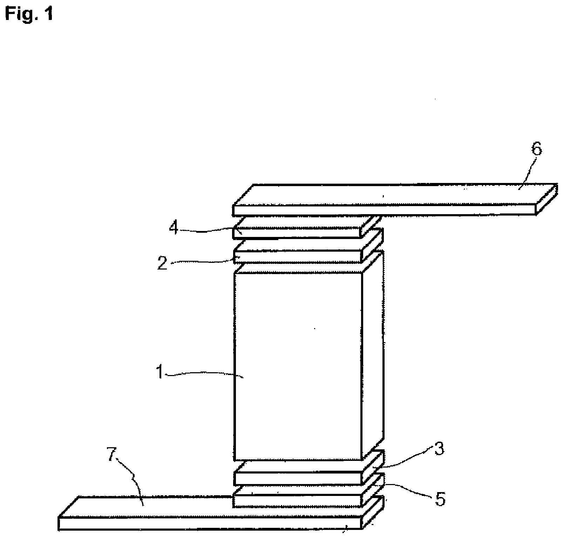

An essential element of thermoelectric components is the contacting. The contacting establishes the physical connection between the material in the "heart" of the component (which is responsible for the desired thermoelectric effect of the component) and the "outside world". The structure of such a contact is schematically represented in Fig 1.

The thermoelectric material **1** inside the component provides the actual effect of the component. It is a thermoelectric piece. An electric current and a heat flux flow through the material **1,** in order for it to fulfill its function in the overall structure.

The material **1** is connected on at least two sides via the contacts **4** and **5** to the leads **6** and **7,** respectively. The layers **2** and **3** are in this case intended to symbolize one or more optionally required intermediate layers (barrier material, solder, bonding agent etc.) between the material and the contacts **4** and **5.** The segments **2/3, 4/5, 6/7** respectively associated with one another pairwise may be identical, although they do not have to be. This will in the end depend likewise on the specific structure and the application, as well as the flow direction of electric current or heat flux through the structure.

The contacts **4** and **5** now have an important role. They ensure a tight connection between material and leads. If the contacts are poor, then high losses occur here and can greatly restrict the performance of the component. For this reason, the pieces and contacts are often pressed onto the material for use. The contacts are thus exposed to a strong mechanical load. This mechanical load increases further whenever elevated (or reduced) temperatures and/or thermal cycling are involved. The thermal expansion of the materials built into the component inevitably leads to mechanical stresses, which in the extreme case lead to failure of the component by fracture of the contact.

In order to prevent this, the contacts used must have a certain flexibility and resilient properties, so that such thermal stresses can be compensated for.

In order to impart stability to the entire structure, and ensure the required maximally homogeneous thermal coupling over every one of the pieces, carrier plates are necessary. To this end a ceramic is conventionally used, for example made of oxides or nitrides such as Al₂O₃, SiO₂ or AlN.

The conventional structure is often subject to limitations in respect of an application, since in each case only planar surfaces can be brought in contact with the thermoelectric module. A tight connection between the module surface and the heat source/heat sink is indispensable in order to ensure a sufficient heat flux.

Nonplanar surfaces, for example a round waste heat pipe, are not suitable for direct contact with the conventional module or they require a corresponding straight heat exchanger structure, in order to provide a transition from the nonplanar surface to the planar module.

Currently, attempts are being made to provide thermoelectric modules in motor vehicles such as automobiles and trucks, in the exhaust system or the exhaust gas recirculation, in order to obtain electrical energy from a part of the exhaust gas heat. In this case, the hot side of the thermoelectric element is connected to the exhaust gas or tailpipe, while the cold side is connected to a cooler. The amount of electricity which can be generated depends on the temperature of the exhaust gas and the heat flux from the exhaust gas to the thermoelectric material. In order to maximize the heat flux, devices are often built into the tailpipe. These are subject to limitations, however, since for example the installation of a heat exchanger often leads to a pressure loss in the exhaust gas, which in turn leads to an intolerable increased consumption of the internal combustion engine.

Conventionally, the thermoelectric generator is installed for use behind the exhaust gas catalytic converter in the exhaust system. Together with the pressure loss of the exhaust gas catalytic converter, this often leads to excessive pressure losses so that thermally conductive devices cannot be provided in the exhaust system; rather, the thermoelectric module bears on the outside of the tailpipe. To this end, the tailpipe must often be configured with a polygonal cross section so that planar external surfaces can come in tight contact with the thermoelectric material.

WO 2010/130764 discloses a heat exchanger and method for converting thermal energy of a fluid into electrical energy by means of a thermoelectric module. The flow channel guiding the fluid is made from a ceramic material in order to reduce thermal expansion.

DE 20 2010 003 049 U1 relates to an apparatus for using motorvehicle exhaust gas to generate electric energy via a thermoelectric generator module. The flow of the exhaust gas can be directed through the thermoelectric module or via a bypass.

European patent application 10 100 614.7, filed on November 10, 2010, and European patent application 10 186 366.0, filed on October 4, 2010, both not published at the filing date of the present patent application, relate to thermoelectric modules consisting of a thermoelectric module which is thermally conductively connected to a micro heat exchanger.

US2010/0212712 A1 discloses a thermoelectric generator having a hot side heat exchanger comprising: a silicon carbide (SiC) honeycomb support with a plurality of passages. The passage walls are coated with a pyrophoric solid fuel such as red oxide (Fe2O3) in combination with a silicon (Si) binder. A quantum well thermoelectric device is positioned between the hot side heat exchanger and heat sink. The performance of the thermoelectric generator is comparable to fuel cells. The thermoelectric generator is small and portable.

Neither the heat transfer, nor pressure losses which occur, have to date been satisfactory.

The system of thermoelectric module and micro heat exchanger is sometimes complicate to assembly. A facilitated assembly of the thermoelectric module/micro heat exchanger system is required.

It is an object of the present invention to provide a thermoelectric module for installation in the exhaust system of an internal combustion engine, which avoids the disadvantages of the known modules and ensures better heat transfer with a low pressure loss and an easier assembly.

The object is achieved according to the invention by a thermoelectric module consisting of p- and n-conducting thermoelectric material pieces which are alternately connected to one another via electrically conductive contacts, wherein the thermoelectric module (19) is thermally conductively connected to a micro heat exchanger (13) which comprises a plurality of continuous channels having a diameter of at most 1 mm, through which a fluid heat exchanger medium can flow, wherein the micro heat exchanger (13) is formed integrally with the thermoelectric module (19), in a way that the micro heat exchanger (13) has an integrally moulded container which receives the p- and n-conducting thermoelectric material pieces which are alternately connected to one another via electrically conductive contacts, to form an integrated assembly of micro heat exchanger (13) and thermoelectric module (19), wherein the channels of the micro heat exchanger are coated with a washcoat of a motor vehicle exhaust gas catalyst.

According to the invention, the channels of the micro heat exchanger are coated with a washcoat of an internal combustion engine exhaust gas catalyst, in particular a motor vehicle exhaust gas catalyst. In this way, a separate exhaust gas catalytic converter can be obviated and the pressure loss in the exhaust system is minimized. The integrated design simplifies the overall structure and facilitates installation in the exhaust system.

By using micro heat exchangers, it is possible to ensure an improved heat flux from the exhaust gas to the thermoelectric module, with at the same time a sufficiently low pressure loss. According to the invention, the exhaust gas flows through the microchannels of the micro heat exchanger. The channels are in this case preferably coated with an exhaust gas catalyst, which in particular catalyzes one or more of the conversions: NOₓ to nitrogen, hydrocarbons to CO₂ and H₂O, and CO to CO₂. Particularly preferably, all these conversions are catalyzed.

Suitable catalytically active materials such as Pt, Ru, Ce, Pd are known, and are described for example in Stone, R. et al., Automotive Engineering Fundamentals, Society of Automotive Engineers 2004. These catalytically active materials are applied in a suitable way onto the channels of the micro heat exchanger. Preferably, application in the form of a washcoat may be envisaged. In this case, the catalyst is applied in the form of a suspension as a thin layer onto the inner walls of the micro heat exchanger, or onto its channels. The catalyst may then consist of a single layer or various layers with identical or varying composition. The applied catalyst may then fully or partially replace the normally used exhaust gas catalytic converter of the internal combustion engine during use in a motor vehicle, depending on the dimensioning of the micro heat exchanger and its coating.

According to the invention, the term "micro heat exchanger" is intended to mean heat exchangers which have a plurality of continuous channels with a diameter of at most 1 mm, particularly preferably at most 0.8 mm. The minimum diameter is set only by technical feasibility, and is preferably of the order of 50 µm, particularly preferably 100 µm.

The channels may have any suitable cross section, for example round, oval, polygonal such as square, triangular or star-shaped, etc. Here, the shortest distance between opposite edges or points of the channel is considered as the diameter. The channels may also be formed so as to be flat, in which case the diameter is defined as the distance between the bounding surfaces. This is the case in particular for heat exchangers which are constructed from plates or layers. In this case, the container is integrally moulded with at least one of these plates or layers. During operation, a heat exchanger medium flows through the continuous channels while transferring heat to the heat exchanger. The heat exchanger is on the other hand integrally moulded and thus thermally connected to the thermoelectric module, so that good heat transfer is obtained from the heat exchanger to the thermoelectric module.

The micro heat exchanger and container may be constructed in any suitable way from any suitable materials. It may for example be made from a block of a thermally conductive material, into which the continuous channels and the container are introduced.

Any suitable materials may be used as the material, such as plastics, for example polycarbonate, liquid crystal polymers such as Zenith® from DuPont, polyether ether ketones (PEEK), etc. Metals may also be used, such as iron, copper, aluminum or suitable alloys such as chromium-iron, Fecralloy. Ceramics or inorganic oxide materials may furthermore be used, such as aluminum oxide or zirconium oxide or cordierite. It may also be a composite material made of a plurality of the aforementioned materials. The micro heat exchanger is preferably made of a high temperature-resistant alloy (1000-1200°C), Fecralloy, iron alloys containing Al, stainless steel, cordierite. The microchannels may be introduced into a block of a thermally conductive material in any suitable way for example by laser methods, etching, boring, etc.

As an alternative, the micro heat exchanger and container may also be constructed from different plates, layers or tubes, which are subsequently connected to one another, for example by adhesive bonding or welding. The plates, layers or tubes may in this case be provided in advance with the microchannels and then assembled. In this case, the container which receives the p- and n-conducting thermoelectric material pieces is integrally moulded to at least one of the plates, layers or tubes.

It is particularly preferred to produce the micro heat exchanger and container from a powder by means of a sintering method. Both metal powders and ceramic powders can be used as the powder. Mixtures composed of metal and ceramic, composed of different metals or composed of different ceramics are also possible. Suitable metal powders comprise, for example, powders composed of ferritic steels, Fecralloy or stainless steel. The production of the micro heat exchanger by means of a sintering method makes it possible to manufacture any desired structure.

Most preferably, the micro heat exchanger (13) which has the integrally moulded container is formed by Selective Laser Sintering (SLS). This allows for the easy assembly of the integrated micro heat exchanger/thermoelectric module container-system with nearly any desirable three-dimensional shape or structure. Selective Laser Sintering techniques are known to a person skilled in the art.

The use of a metal as material for the micro heat exchanger and container affords the advantage of a good thermal conductivity. By contrast, ceramics have a good heat storage capability, and so they can be utilized, in particular, to compensate for temperature fluctuations.

If plastics are used as material for the micro heat exchanger and container, it is necessary to apply a coating that protects the plastic from the temperatures of the exhaust gas flowing through the micro heat exchanger. Such coatings are also referred to as "thermal barrier coating". On account of the high temperatures of the exhaust gas, it is necessary to coat all surfaces of the micro heat exchanger composed of the plastics material.

The external dimensions of the micro heat exchanger used according to the invention are preferably from 60 x 60 x 20 to 40 x 40 x 8 mm³.

The specific heat transfer area of the micro heat exchanger, in relation to the volume of the micro heat exchanger, is preferably from 0.1 to 5 m²/l, particularly preferably from 0.3 to 3 m²/l, in particular from 0.5 to 2 m²/l.

Suitable micro heat exchangers are commercially available, for example from the Institut für Mikrotechnik Mainz GmbH. The IMM offers various geometries of microstructured heat exchangers, and in particular microstructured high-temperature heat exchangers for a maximum operating temperature of 900°C. These high-temperature heat exchangers have dimensions of about 80 x 50 x 70 mm³ and function (for other applications) according to the counterflow principle. They have a pressure loss of less than 50 mbar and a specific heat transfer area of about 1 m²/l.

Other micro heat exchangers are exhibited by VDI/VDE-Technologiezentrum Informationstechnik GmbH (www.nanowelten.de). Micro heat exchangers are furthermore offered by Ehrfeld Mikrotechnik BTS GmbH, Wendelsheim and SWEP Market Services, a branch of Dover Market Services GmbH, Fürth.

The micro heat exchanger known from the above sources must be adapted for use in the thermoelectric module according to the present invention. Thus, an integrally moulded container has to be preformed or formed on the micro heat exchanger. Typically, the assembly of micro heat exchanger and thermoelectric module is a "one piece" component which is preferably obtained in one process by Selective Laser Sintering (SLS).

The micro heat exchanger is thus connected to the thermoelectric module in a way which has the best possible thermal conduction. It is thus thermally conductively connected directly to the thermoelectric module.

The pressure loss generated through the continuous channels of the heat exchanger for a gas flowing through is preferably at most 100 mbar, in particular at most 50 mbar. Such pressure losses do not lead to an increased fuel consumption of the internal combustion engine. Such a pressure loss can be realized, in particular if the micro heat exchangers are arranged such that the channels through which the exhaust gas flows run parallel and are connected to an inlet on one side and to an outlet on the other side. The length of the channels through which the exhaust gas flows is in this case preferably at most 60 mm, in particular at most 40 mm. If more than one micro heat exchanger is used, the micro heat exchangers are likewise connected in parallel and connected to a common inlet and a common outlet, such that the channels of the individual heat exchangers likewise run parallel.

The heat-exchanging surface of the micro heat exchanger may be installed directly in the exhaust system or tailpipe of an internal combustion engine, in particular of a motor vehicle. It may in this case be installed fixed or removably. The heat-exchanging surface is preferably firmly encapsulated with the thermoelectric module.

If the micro heat exchanger is provided with a washcoat of the catalyst material, it may be installed in the exhaust system at the position of the original exhaust gas catalytic converter. In this way, a high exhaust gas temperature can be supplied to the micro heat exchanger. The temperature may be increased even further by the chemical conversion at the exhaust gas catalyst of the micro heat exchanger, so that much more efficient heat transfer takes place than in known systems.

An improved efficiency of the thermoelectric module is also achieved by the improved heat flux, due to the integrated assembly of microheat exchanger and thermoelectric module.

A protective layer for protecting against excessive temperatures may furthermore be provided inside the container next to the micro heat exchanger. This layer, also referred to as a phase-change layer, is preferably made of inorganic metal salts or metal alloys having a melting point in the range of from 250°C to 1700°C. Suitable metal salts are for example fluorides, chlorides, bromides, iodides, sulfates, nitrates, carbonates, chromates, molybdates, vanadates and tungstates of lithium, sodium, potassium, rubidium, cesium, magnesium, calcium, strontium and barium. Mixtures of suitable salts of this type, which form double or triple eutectics, are preferably used. They may also form quadruple or quintuple eutectics.

Alternatively, it is possible to use metal alloys as phase-change materials and combinations thereof, which form double, triple, quadruple or quintuple eutectics, starting from metals such as zinc, magnesium, aluminum, copper, calcium, silicon, phosphorus and antimony. The melting points of the metal alloys should in this case lie in the range of from 200°C to 1800°C.

The thermoelectric module may be encapsulated with the protective layer, in particular when using metals such as nickel, zirconium, titanium, silver and iron, or when using alloys based on nickel, chromium, iron, zirconium and/or titanium.

One or more of the thermoelectric modules, for example connected in succession, may be integrated into the exhaust system of the internal combustion engine. In this case, thermoelectric modules comprising different thermoelectric materials may also be combined. In general, it is possible to use all suitable thermoelectric materials which are suitable for the temperature range of an exhaust gas of an internal combustion engine. Examples of suitable thermoelectric materials are skutterudites, for example CoSb₃, RuPdSb₆, TX₆ with T = Co, Rh, Ir and X = P, As, Sb; X₂Y₈Z₂₄ with X = lanthanides, actinides, alkaline earth metals, alkali metals, Th, group IV elements; half-Heusler compounds such as TiNiSn, HfPdSn and intermetallic alloys; clathrates such as Zn₄Sb₃, Sr₈Ga₁₆Ge₃₀, Cs₈Sn₄₄, Co₄TeSb₄; oxides such as NaₓCoO₂, CaCo₄O₉, Bi₂Sr₂Co₂O_{y}Sr₂TiO₄, Sr₃Ti₂O₇, Sr₄Ti₃O₁₀, R₁₋ₓMₓCoO₃ with R = rare earth metal and M = alkaline earth metal; Srₙ₊₁TiₙO₃ₙ₊₁, where n is an integer; YBa₂Cu₃O₇₋ₓ; silicides such as FeSi₂, Mg₂Si, Mn₁₅Si₂₆; borides such as B₄C, CaB₆; Bi₂Ce₃ and derivatives thereof, PbCe and derivatives thereof, antimonides such as zinc antimonide, Zintl phases such as Yb₁₄MnSb₄.

In the thermoelectric module according to the present invention, preferably in the container, hot side electrically conductive contacts are placed, an extract solid matrix structure is inserted afterwards, which has recesses to house the p- and n-conducting thermoelectric material pieces inserted therein, cold side electrically conductive contacts are placed on the p- and n-conducting thermoelectric materials and finally cold side electrical insulation is applied, in order to form the thermoelectric module (19).

In a process for preparing a thermoelectric module according to the present invention, the above process steps are performed.

The container can have any desired redimensional shape, as long as it can house the thermoelectric material pieces, the electrical contact and the other layers described. Typically, the container has the form of a box, into which the thermoelectric module is filled. Preferably, the bottom of the box is electrically insulated by an insulating layer made of for example ceramics, glass etc., by known coating processes like spraying, CVD, PVD, galvanic processes, casting, etc.

In a next step, electrically conductive contacts, forming the hot side electrically conductive contacts of the thermoelectric module, are placed on the respective positions in the container or box. These electrically conducting contacts can be made of any desired electrically conducting materials like metals, i.e. copper, iron, nickel, etc. These contacts may be placed in the container or fixed by gluing or soldering or by placing in respective recesses of the container.

In a next step, an eggcrate solid matrix structure is inserted, which fills the container but has recesses to house the p- and n-conducting thermoelectric material pieces inserted therein. The eggcrate solid matrix structure can be formed of any suitable material like ceramics, polymers, aerogel, wood, foam or metal like steel. The eggcrate solid matrix structure has recesses of the size of the p- and n-conducting thermoelectric material pieces. The eggcrate can be formed from one or more pieces which can be layered onto each other. The eggcrate can have recesses or holes of any possible diameter and geometry.

Preferably, the eggcrate solid matrix material is selected from polymers or ceramics due to the low thermal connectivity, minimizing heat losses.

The p- and n-conducting thermoelectric material pieces are then inserted in the recesses of the eggcrate matrix structure, in alternating n- and p-order. The material pieces can be contacted with the electrically conductive contacts in any suitable manner, like soldering, glueing, clamping or pressing.

Cold side electrically conductive contacts are placed on the p- and n-conducting thermoelectric materials, so that also the cold side of the thermoelectric modules is electrically connected. Finally, a cold side electrical insulation is applied, in order to form the thermoelectric module (19). This insulating layer may be formed of ceramics, glass, glimmer or other coatings.

The invention also relates to the use of a thermoelectric module as described above in the exhaust system of an internal combustion engine, preferably in a motor vehicle such as an automobile or truck. In this case, the thermoelectric module is used in particular for generating electricity from the heat of the exhaust gas.

When there is a washcoat on the micro heat exchanger, however, the thermoelectric module may also be used in reverse for preheating the exhaust gas catalyst during a cold start of an internal combustion engine, preferably of a motor vehicle. In this case, the thermoelectric module is used as a Peltier element. When a voltage difference is applied to the module, the module transports heat from the cold side to the hot side. The preheating of the exhaust gas catalyst due to this reduces the cold start time of the catalyst.

The invention furthermore relates to an exhaust system of an internal combustion engine, preferably of a motor vehicle, comprising one or more thermoelectric modules as described above, integrated into the exhaust system

In this case, the exhaust system is intended to mean the system which is connected to the outlet of an internal combustion engine and in which the exhaust gas is processed. The thermoelectric module according to the invention has many advantages. The pressure loss in the exhaust system of an internal combustion engine is low, in particular when the micro heat exchanger is coated with a washcoat of the exhaust gas catalyst. The structure of the exhaust system can be simplified significantly by the one integrated component. Since the integrated component can be integrated closer to the internal combustion engine in the exhaust system, higher exhaust gas temperatures can be supplied to the thermoelectric module. By the reverse use of the thermoelectric module as a Peltier element, the exhaust gas catalyst can be heated during a cold start of the engine.

Exemplary embodiments of the invention are illustrated in the figures and are explained in greater detail in the following description.

In the figures:
- figure 3: shows a three-dimensional illustration of a construction of a thermoelectric generator,
- figure 4: shows a three-dimensional illustration of a layer construction of a thermoelectric generator.

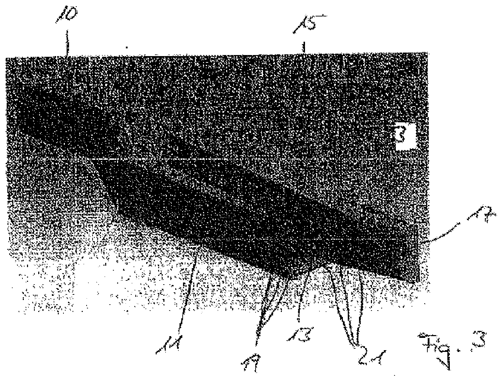

Figure 3 illustrates a construction of a thermoelectric generator such as can be inserted into the exhaust system of a motor vehicle, for example.

An exhaust pipe 10, through which exhaust gases are led away from an internal combustion engine, leads to a manifold 11. The manifold 11 has a cross-sectional area that decreases in the flow direction of the exhaust gas. The manifold 11 is adjoined by micro heat exchangers 13. The latter are connected to the manifold 11 in such a way that the exhaust gas flows through channels in the micro heat exchangers 13. The channels in the micro heat exchangers lead to a collector 15, via which the exhaust gas, after the latter has flowed through the channels in the micro heat exchangers, is conducted into a further exhaust pipe 17, which usually ends in an exhaust of the internal combustion engine.

The micro heat exchangers 13 have each integrated on one side a thermoelectric module 19. The thermoelectric module 19 is cooled on the opposite side to the micro heat exchanger. For this purpose, use is preferably made of a cooling liquid, for example cooling water, which flows over the thermoelectric module 19. In this case, it is firstly possible to conduct the cooling liquid through channels in a heat exchanger, for example a micro heat exchanger. It is preferred, however, to provide a cooling channel 21, through which the cooling liquid flows, on that side of the thermoelectric module 19 which is to be cooled, wherein a wall of the cooling channel 21 is formed by the thermoelectric module 19.

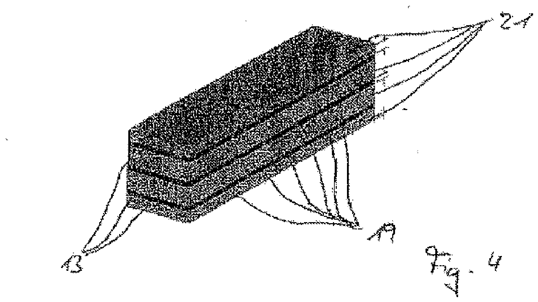

In one preferred embodiment, micro heat exchanger 13, thermoelectric module 19 assemblies and cooling channels 21 are stacked, wherein the micro heat exchangers 13 situated in the inner portion have in each case integrated at their opposite sides a thermoelectric module 19 and, accordingly, the cooling channels 21 situated in the inner portion are also connected in each case at their opposite sides to a thermoelectric module 19. A corresponding layer construction is illustrated by way of example in figure 4. Here the layer construction is bounded by a cooling channel in each case at the top side and at the underside. The cooling channel 21 is adjoined by a thermoelectric module 19, which is integrally formed on the opposite side to a micro heat exchanger 13. The micro heat exchanger 13 is followed by a further thermoelectric module 19 and a further cooling channel 21.

The layer construction makes it possible to utilize the heat of the exhaust gas as well as possible and to use a large number of thermoelectric modules 19 in a small space.

Besides the embodiment illustrated in figures 3 and 4 with a layer construction wherein the individual layers run parallel to the main flow axis of the exhaust pipe 10, it is also possible to design the layer construction such that the individual layers run perpendicularly to the main flow axis of the exhaust pipe 10. Independently of the orientation of the individual layers, however, the channels in the micro heat exchangers 13 preferably always run transversely with respect to the main flow direction of the exhaust pipe 10 from the manifold 11 to the collector 15.

In the case of an orientation of the layers as illustrated in figures 3 and 4, the individual layers can comprise in each case one micro heat exchanger 13 with one thermoelectric module 19 or alternatively a plurality of micro heat exchangers 13 with a plurality of thermoelectric modules 19, which are respectively assembled alongside one another. In this embodiment, it is then possible to form a plurality of stacks which are subsequently connected to one another in series, wherein the individual stacks are preferably oriented such that the respective cooling channels 21 adjoin one another with their inlets and outlets, thus forming cooling channels that are continuous over the series of the stacks. In this case, the orientation of the cooling channels is chosen such that the cooling liquid and the exhaust gas are guided in cross-flow relative to one another. Alternatively, it is also possible, of course, to orient the cooling channels in any other direction desired. Thus, the cooling channels can, for example, also run parallel to the channels in the micro heat exchangers.

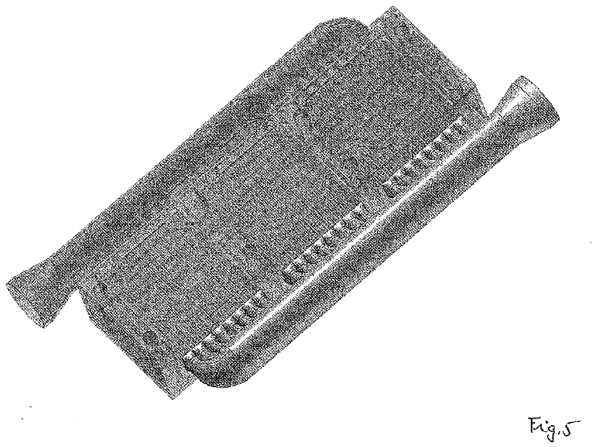

Figures 5 to 7 show different views of an integrated assembly of micro heat exchangers and thermoelectric modules, having a plurality of continuous channels.

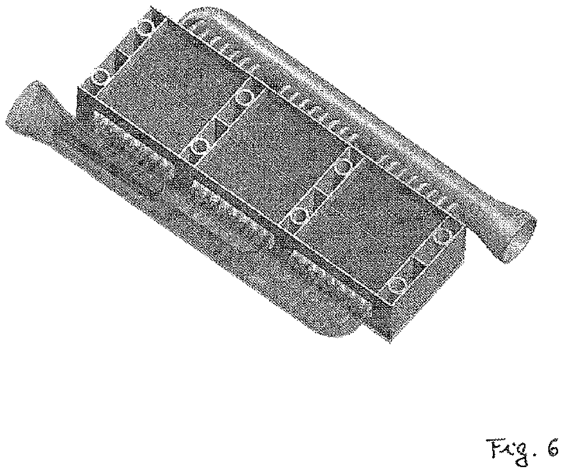

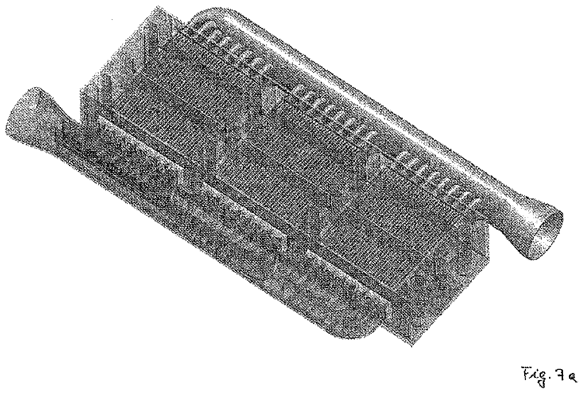

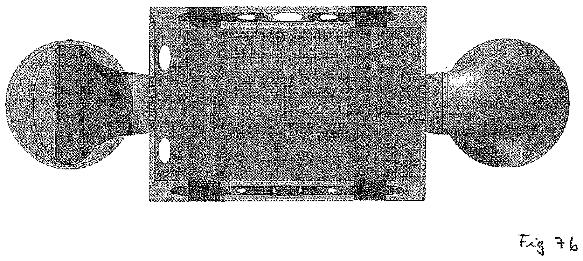

Figure 6 shows the assembly with the containers for the thermoelectric materials, whereas figure 7 shows the flow channels in the micro heat exchanger. Figure 5 shows the total assembly with the different flow channels.

## Claims

1. An integrated assembly of micro heat exchanger and thermoelectric module consisting of p- and n-conducting thermoelectric material pieces which are alternately connected to one another via electrically conductive contacts, wherein the thermoelectric module (19) is thermally conductively connected to a micro heat exchanger (13) which comprises a plurality of continuous channels having a diameter of at most 1 mm, through which a fluid heat exchanger medium can flow, wherein the micro heat exchanger (13) is formed integrally with the thermoelectric module (19), in a way that the micro heat exchanger (13) has an integrally moulded container which receives the p- and n-conducting thermoelectric material pieces which are alternately connected to one another via electrically conductive contacts, to form an integrated assembly of micro heat exchanger (13) and thermoelectric modules (19), **characterized in that** the channels of the micro heat exchanger are coated with a washcoat of a motor vehicle exhaust gas catalyst.

2. The integrated assembly according to claim 1, wherein a protective layer for protecting against excessive temperatures is provided inside the container on a surface next to the micro heat exchanger (13).

3. The integrated assembly according to claim 2, wherein the protective layer is made of inorganic metal salts or metal alloys having a melting point in the range of from 250°C to 1700°C.

4. The integrated assembly according to claim 1, wherein the catalyst catalyzes at least one of the conversions: NOₓ to nitrogen, hydrocarbons to CO₂ and H₂O, and CO to CO₂.

5. The integrated assembly according to one of claims 1 to 4, wherein the pressure loss generated through the continuous channels of the heat exchanger for a gas flowing through is at most 100 mbar, wherein the diameter of the continuous channels is at most 0.8 mm.

6. The integrated assembly according to one of claims 1 to 4, wherein the micro heat exchanger is made from a block of a thermally conductive material, into which the continuous channels and the container are introduced.

7. The integrated assembly according to one of claims 1 to 4, wherein the specific heat transfer area, in relation to the volume of the micro heat exchanger, is from 0.1 to 5 m²/l.

8. The use of an integrated assembly according to one of claims 1 to 7 in exhaust system of an internal combustion engine, preferably in a motor vehicle.

9. The use of an integrated assembly according to claim 8 for generating electricity from the heat of the exhaust gas.

10. The use of an integrated assembly according to claim 4 in preheating the exhaust gas catalyst during a cold start of an internal combustion engine, preferably of a motor vehicle.

11. An exhaust system of an internal combustion engine, preferably of a motor vehicle, comprising one or more integrated assembly(ies) according to one of claims 1 to 7, integrated into the exhaust system.

12. A process for preparing an integrated assembly according to one of claims 1 to 7, in which process electrically conductive contacts are placed in the container, an eggcrate solid matrix structure is inserted afterwards, which has recesses to house the p- and n-conducting thermoelectric material pieces inserted therein, cold side electrically conductive contacts are placed on the p- and n-conducting thermoelectric materials and finally cold side electrical insulation is applied, in order to form the thermoelectric module (19) and wherein the micro heat exchanger (13) is formed integrally with the thermoelectric module (19), in a way that the miccro heat exchanger (13) as an integrally moulded container which receives the p- and n-conducting thermoelectric material pieces which are alternately connected to one another via electrically conductive contacts, to form the integrated assembly of micro heat exchanger (13) and thermoelectric module (19), wherein the channels of the micro heat exchanger are coated with a washcoat of a motor vehicle exhaust gas catalyst.

13. The process according to claim 12, wherein the micro heat exchanger (13), which has the integrally moulded container is formed by selective Laser Sintering (SLS).

## Patentansprüche

1. Integrierte Anordnung aus Mikrowärmetauscher und thermoelektrischem Modul, die aus p- und n-leitenden thermoelektrischen Materialstücken besteht, die wechselweise miteinander über elektrisch leitfähige Kontakte verbunden sind, wobei das thermoelektrische Modul (19) thermisch leitend mit einem Mikrowärmetauscher (13) verbunden ist, der mehrere durchgehende Kanäle mit einem Durchmesser von höchstens 1 mm umfasst, durch die ein fluides Wärmetauschermedium strömen kann, wobei der Mikrowärmetauscher (13) einstückig mit dem thermoelektrischen Modul (19) gebildet ist, in einer Weise, dass der Mikrowärmetauscher (13) einen angeformten Behälter aufweist, der die p- und n-leitenden thermoelektrischen Materialstücke aufnimmt, die wechselweise miteinander über elektrisch leitfähige Kontakte verbunden sind, so dass sie eine integrierte Anordnung aus Mikrowärmetauscher (13) und thermoelektrischem Modul (19) bilden, **dadurch gekennzeichnet, dass** die Kanäle des Mikrowärmetauschers mit einem Washcoat eines Kraftfahrzeug-Abgaskatalysators überzogen sind.

2. Integrierte Anordnung nach Anspruch 1, wobei eine Schutzschicht zum Schützen gegen überhöhte Temperaturen im Inneren des Behälters auf einer Oberfläche neben dem Mikrowärmetauscher (13) bereitgestellt ist.

3. Integrierte Anordnung nach Anspruch 2, wobei die Schutzschicht aus anorganischen Metallsalzen oder Metalllegierungen mit einem Schmelzpunkt im Bereich von 250 °C bis 1700 °C hergestellt ist.

4. Integrierte Anordnung nach Anspruch 1, wobei der Katalysator wenigstens eine der folgenden Umsetzungen katalysiert: NOₓ zu Stickstoff, Kohlenwasserstoffe zu C0₂ und H₂O und CO zu C0₂.

5. Integrierte Anordnung nach einem der Ansprüche 1 bis 4, wobei der Druckverlust, der durch die durchgehenden Kanäle des Wärmetauschers für ein durchströmendes Gas erzeugt wird, höchstens 100 mbar beträgt, wobei der Durchmesser der durchgehenden Kanäle höchstens 0,8 mm beträgt.

6. Integrierte Anordnung nach einem der Ansprüche 1 bis 4, wobei der Mikrowärmetauscher aus einem Block eines thermisch leitfähigen Materials hergestellt ist, in den die durchgehenden Kanäle und der Behälter eingebracht sind.

7. Integrierte Anordnung nach einem der Ansprüche 1 bis 4, wobei die spezifische Wärmeübertragungsfläche im Verhältnis zum Volumen des Mikrowärmetauschers 0,1 bis 5 m²/l beträgt.

8. Verwendung einer integrierten Anordnung nach einem der Ansprüche 1 bis 7 in einem Abgassystem einer Brennkraftmaschine, vorzugsweise in einem Kraftfahrzeug.

9. Verwendung einer integrierten Anordnung nach Anspruch 8, um aus der Wärme des Abgases Elektrizität zu erzeugen.

10. Verwendung einer integrierten Anordnung nach Anspruch 4 beim Vorwärmen des Abgaskatalysators während eines Kaltstarts einer Brennkraftmaschine, vorzugsweise eines Kraftfahrzeugs.

11. Abgassystem einer Brennkraftmaschine, vorzugsweise eines Kraftfahrzeugs, das eine oder mehrere integrierte Anordnung(en) nach einem der Ansprüche 1 bis 7 umfasst, die in das Abgassystem integriert ist/sind.

12. Prozess zum Herstellen einer integrierten Anordnung nach einem der Ansprüche 1 bis 7, wobei in diesem Prozess elektrisch leitfähige Kontakte im Behälter platziert werden, danach eine eierkartonförmige Matrixstruktur eingefügt wird, die Aussparungen aufweist, um die p- und n-leitenden thermoelektrischen Materialstücke aufzunehmen, die darin eingefügt werden, elektrisch leitfähige Kontakte auf der Kaltseite auf den p- und n-leitenden thermoelektrischen Materialien platziert werden und schließlich elektrische Isolierung auf der Kaltseite angebracht wird, um das thermoelektrische Modul (19) zu bilden, und wobei der Mikrowärmetauscher (13) einstückig mit dem thermoelektrischen Modul (19) gebildet wird, in einer Weise, dass der Mikrowärmetauscher (13) einen angeformten Behälter aufweist, der die p- und n-leitenden thermoelektrischen Materialstücke aufnimmt, die wechselweise miteinander über elektrisch leitfähige Kontakte verbunden sind, so dass sie die integrierte Anordnung aus Mikrowärmetauscher (13) und thermoelektrischem Modul (19) bilden, wobei die Kanäle des Mikrowärmetauschers mit einem Washcoat eines Kraftfahrzeug-Abgaskatalysators überzogen sind.

13. Prozess nach Anspruch 12, wobei der Mikrowärmetauscher (13), der den angeformten Behälter aufweist, durch selektives Lasersintern (SLS) gebildet wird.

## Revendications

1. Ensemble intégré de micro-échangeur de chaleur et de module thermoélectrique constitué de pièces de matériaux thermoélectriques conducteurs p et n qui sont connectées en alternance les unes aux autres par l'intermédiaire de contacts électriquement conducteurs, dans lequel le module thermoélectrique (19) est raccordé de façon thermiquement conductrice à un micro-échangeur de chaleur (13) qui comprend une pluralité de canaux continus ayant un diamètre d'au maximum 1 mm, dans lesquels un milieu échangeur de chaleur fluide peut circuler, dans lequel le micro-échangeur de chaleur (13) est formé d'un seul tenant avec le module thermoélectrique (19), d'une manière telle que le micro-échangeur de chaleur (13) a un contenant moulé d'un seul tenant qui reçoit les pièces de matériaux thermoélectriques conducteurs p et n qui sont connectées en alternance les unes aux autres par l'intermédiaire de contacts électriquement conducteurs, pour former un ensemble intégré de micro-échangeur de chaleur (13) et de module thermoélectrique (19), **caractérisé en ce que** les canaux du micro-échangeur de chaleur sont revêtus d'une couche d'imprégnation d'un catalyseur pour du gaz d'échappement de véhicule à moteur.

2. Ensemble intégré selon la revendication 1, dans lequel une couche protectrice pour la protection contre des températures excessives est disposée à l'intérieur du contenant sur une surface à côté du micro-échangeur de chaleur (13).

3. Ensemble intégré selon la revendication 2, dans lequel la couche protectrice est constituée de sels métalliques inorganiques ou d'alliages métalliques ayant un point de fusion dans la plage de 250 °C à 1700 °C.

4. Ensemble intégré selon la revendication 1, dans lequel le catalyseur catalyse au moins l'une des conversions : NOₓ en azote, hydrocarbures en CO₂ et H₂O et CO en CO₂.

5. Ensemble intégré selon l'une des revendications 1 à 4, dans lequel la perte de pression produite dans les canaux continus de l'échangeur de chaleur pour un gaz y circulant est d'au maximum 100 mbar, dans lequel le diamètre des canaux continus est d'au maximum 0,8 mm.

6. Ensemble intégré selon l'une des revendications 1 à 4, dans lequel le micro-échangeur de chaleur est formé à partir d'un bloc d'un matériau thermiquement conducteur, dans lequel les canaux continus et le contenant sont introduits.

7. Ensemble intégré selon l'une des revendications 1 à 4, dans lequel la surface spécifique de transfert de chaleur, par rapport au volume du micro-échangeur de chaleur, est de 0,1 à 5 m²/l.

8. Utilisation d'un ensemble intégré selon l'une des revendications 1 à 7 dans un système d'échappement d'un moteur à combustion interne, de préférence dans un véhicule à moteur.

9. Utilisation d'un ensemble intégré selon la revendication 8 pour la production d'électricité à partir de la chaleur du gaz d'échappement.

10. Utilisation d'un ensemble intégré selon la revendication 4 en préchauffage du catalyseur pour du gaz d'échappement pendant un démarrage à froid d'un moteur à combustion interne, de préférence d'un véhicule à moteur.

11. Système d'échappement d'un moteur à combustion interne, de préférence d'un véhicule à moteur, comprenant un ou plusieurs ensembles intégrés selon l'une des revendications 1 à 7, intégrés dans le système d'échappement.

12. Procédé pour la préparation d'un ensemble intégré selon l'une des revendications 1 à 7, dans lequel procédé des contacts électriquement conducteurs sont placés dans le contenant, une structure de matrice solide en alvéoles est ensuite insérée, laquelle a des renfoncements pour loger les pièces de matériaux thermoélectriques conducteurs p et n qui y sont insérés, des contacts électriquement conducteurs du côté froid sont placés sur les matériaux thermoélectriques conducteurs p et n et enfin un isolant électrique du côté froid est appliqué, afin de former le module thermoélectrique (19) et dans lequel le micro-échangeur de chaleur (13) est formé d'un seul tenant avec le module thermoélectrique (19), d'une manière telle que le micro-échangeur de chaleur (13) a un contenant moulé d'un seul tenant qui reçoit les pièces de matériaux thermoélectriques conducteurs p et n qui sont connectées en alternance les unes aux autres par l'intermédiaire de contacts électriquement conducteurs, pour former l'ensemble intégré de micro-échangeur de chaleur (13) et de module thermoélectrique (19), dans lequel les canaux du micro-échangeur de chaleur sont revêtus d'une couche d'imprégnation d'un catalyseur pour du gaz d'échappement de véhicule à moteur.

13. Procédé selon la revendication 12, dans lequel le micro-échangeur de chaleur (13), qui a le contenant moulé d'un seul tenant, est formé par frittage sélectif par laser (SLS).
